# EUROPÄISCHE PATENTANMELDUNG

(11) **EP 1 050 875 A2**
(43) Veröffentlichungstag der Anmeldung: **08.11.2000**
(21) Anmeldenummer: 00109351.7
(22) Anmeldetag: 02.05.2000
(51) Int. Cl.: G11B 7/26

(54) **Herstellung einer Pressform für Compact Discs**

(30) Priorität: 29.04.1999 DE 19919764
(71) Anmelder: Innovators AG, 8212 Neuhausen am Rheinfall (CH)
(72) Erfinder: Drecoll, Harm, 8260 Stein am Rhein (CH)
(74) Vertreter: COHAUSZ HANNIG DAWIDOWICZ & PARTNER

(57) **Zusammenfassung**

Verfahren zur Herstellung einer Preßform (Stamper) für die Abformung eines informationstragenden optischen Speichermediums, wobei
- in einem Verfahrensschritt ein eine Deckschicht 3 aus Metall aufweisender Rohling 1 mit einer Schicht von strahlenempfindlichem Material (Resistlack) 5 überzogen wird,
- in einem weiteren Verfahrensschritt der Resistlack 5 mittels einer Strahlenquelle 6 entsprechend der zu speichernden Information beleuchtet wird,
- in einem weiteren Verfahrensschritt der Resistlack 5 einem Entwicklungsprozeß unterzogen wird, so daß die beleuchteten Bereiche 7 bis auf die Deckschicht 3 abgetragen werden,
- in einen weiteren Verfahrensschritt die Vertiefungen 15 bildenden abgetragenen Bereiche 7 in einem galvanischen Prozeß mit Metall 9 aufgefüllt werden und
- in einem weiteren Verfahrensschritt der verbleibende Resistlack 5 entfernt wird.

## Beschreibung

Die Erfindung betrifft ein Verfahren zur Herstellung einer Preßform (Stamper) für die Abformung informationstragender optischer Speichermedien.

Es sind im Wesentlichen zwei Verfahren zur Herstellung eines Stampers bekannt. In einem ersten Verfahren ("Photoresist Mastering") wird ein Rohling in Form einer Glasplatte mit einer photosensiblen Oberfläche mittels eines fokussierten Laserstrahles belichtet. Bei der chemischen Entwicklung der photosensiblen Oberfläche bilden die belichteten Stellen Vertiefungen aus, während die Oberfläche zwischen den belichteten Stellen nicht angegriffen wird. In einem anderen Verfahren ("Non Photoresist Mastering") wird der Rohling mit einer Schicht aus organischem Material (organic dye) versehen. In diese Schicht werden mittels eines Laserstrahles Vertiefungen direkt eingebrannt bzw. eingeschmolzen.

Der auf eine der genannten Arten hergestellte Glasmaster wird mit einer dünnen Metallschicht überzogen, bevor in einem elektrolytischen Prozeß die Vertiefungen aufgefüllt und ein Sockel angeformt wird (Elektroforming). Der Sockel mit den erhabenen Datenstrukturen wird vom Glasmaster getrennt und gereinigt und ist danach als Stamper zu benutzen.

Die Fertigung der CD's erfolgt in einer Spritzgußkammer, in der optisches Polykarbonat unter hohem Druck auf den Stamper gespritzt wird. Danach werden der Stamper und die fertige CD mit Preßluft voneinander getrennt und die Oberfläche der CD verspiegelt und lackiert.

Nachteil der bekannten Verfahren ist, daß sie wegen der vielen Verfahrenschritte sehr aufwendig und teuer sind. Außerdem sind die durch Elektroforming gefertigten Stamper vergleichsweise kurzlebig, da das im galvanischen Prozeß aufgebaute Metall eine geringe Festigkeit besitzt. So können mit einem Stamper lediglich einige Tausend CD's gepreßt werden, bevor die Qualität des Stampers wegen der extremen Verhältnisse in der Spritzgußmaschine (1800 atü und 380°C) verloren gegangen ist.

Es ist außerdem ein Verfahren bekannt, bei dem entsprechend der zu speichernden Information Spuren mit einem Laserstrahl in die von einer Deckschicht überzogene Oberfläche eines Rohlings aus Metall eingebrannt werden, bevor die Spuren in einem galvanischen Prozeß mit Metall aufgefüllt werden.

Nachteilig an diesem Vefahren ist, daß die Intensität das Laserstrahles, mit dem die Spuren in die Deckschicht eingraviert werden, sehr hoch sein muß, um eine saubere Gravur zu erzeugen. Wegen der hohen Intensität ist es aber möglich, daß die Ränder der Spuren angegriffen werden und es nach dem Galvanisieren zu ungleichmäßig starken Auftragungen kommt. Außerdem ist das Verfahren wegen des hohen apparativen Aufwandes teuer und wegen beim Einsatz von Lasern geringerer Intensität vergleichsweise langsam.

Aufgabe der Erfindung ist es, ein Verfahren zu schaffen, mit dem sich bei geringem Zeitaufwand und geringen Kosten widerstansfähige Stamper für die Abformung von optischen Speichermedien (Compact Disks) herstellen lassen.

Diese Aufgabe wird durch das Verfahren nach Anspruch 1 gelöst.

Der wesentliche Vorteil des erfindungsgemäßen Verfahrens ist darin zu sehen, daß die metallische Oberfläche des Rohlings mit einer Schicht aus strahlenempfindlichem Resistlack überzogen wird. Dieser Resistlack braucht dann lediglich entsprechend der zu speichernden Information beleuchtet und anschließend entwickelt werden, wobei nach dem Entwicklungsvorgang erhabene Strukturen zurückbleiben, deren Zwischenräume (Vertiefungen) in einem galvanischen Prozeß mit Metall aufgefüllt werden. Dabei entspricht das im galvanischen Bad freigesetzte Metall dem Metall des Rohlings. Die Vertiefungen können dabei den Pits auf der späteren CD entsprechen.

Der galvanische Prozeß setzt direkt auf der metallischen Deckschicht an. Die Veriefungen werden mitunter bis zur Oberfläche der Schicht des Resistlackes aufgefüllt und bilden damit Auftragungen von etwa 1,5 Mikrometer Stärke. Vorteilhafterweise ist die Schichtdicke des Resistlackes jedoch etwa fünffach höher als die Höhe der abgeschiedenen Relief struktur. Der Prozeß wird dann bei Erreichen dieser Stärke abgebrochen.

Vorteilhaft ist, daß bei Anwendung des erfindungsgemäßen Vefahrens auf bislang notwendige Verfahrensschritte verzichtet werden kann, was die Herstellungskosten der Stamper und damit der Compact Disks senkt. Zur Beleuchtung des Resistlackes sind verschiedene Quellen denkbar, wobei sowohl elektromagnetische als auch korpuskulare Strahlen in Frage kommen. Ein besonderer Vorteil des Verfahrens ist, daß die Deckschicht nunmehr durch den Entwicklungsprozeß an den entsprechenden Stellen abgebaut wird und dies nicht mehr direkt durch die Strahlung bewerkstelligt werden muß. Da für die kurzzeitige Beleuchtung eine wesentlich geringere Intensität als zum Abtragen ausreicht, kann die Leistung der Strahlenquelle entsprechend reduziert werden. Somit wird die Herstellung der Stamper unter Reduzierung der Kosten beschleunigt.

Als Strahlenquellen werden bevorzugt Laser der Wellenlänge von 360 nm oder 450 nm eingesetzt. Mit der gut fokussierten Strahlung derartiger Laser wird eine hohe Schreibqualität erreicht. Dabei sind solche Laser geringer Leistung einfach handhabbar und kostengünstig in der Herstellung. Die Wellenlänge des Lasers kann dabei der Empfindlichkeit der im Resistlack befindlichen Photorezeptoren oder vice versa angepaßt werden.

Um einen kleinen Fokus und damit besonders scharfe Belichtungsspuren zu erhalten ist es vorteilhaft, den aufgebrachten Resistlack mit einem fein fokussierten Ionenstrahl, beispielsweise mit den Elektronen eines fokussierten Kathodenstrahles, zu beleuchten. Die Sensitivität des Lackes wird dann vorteilhafterweise an die Art und die Energie der Strahlung angepaßt.

Ein besonderer Vorteil des erfindungsgemäßen Verfahrens ist, daß die durch den Entwicklunsprozeß entstehenden Vertiefungen wesentlich schärfere Kanten und damit exaktere Querschnitte aufweisen. In Folge dessen ist das auf der metallischen Oberfläche des Rohlings durch Galvanisieren entstehende Relief von höherer Qualität und Schärfe. Es ist zudem vorteilhaft, den Resistlack derart zu gestalten, daß er auf eine höhere Strahlenenergie, die sich entsprechend schärfer fokussieren läßt, sensibel ist. So können Strukturen mit Ausdehnungen von kleiner 0.1 Mikrometer geschaffen werden.

Für die Art der Beleuchtung gibt es zwei Alternativen; Entweder werden die Negativ-Formen für die Pits auf den Rohling aufgebracht (positiver Stamper), oder es wird das die Pits umgebende Relief aufgebracht (negativer Stamper), so daß eine Master CD als Negativform für einen Stamper entsteht. So können mittels der Strahlenquelle auf einer Spirale oder auf konzentrischen Kreisen liegende Spuren beleuchtet werden, die nach der Entwicklung Vertiefungen entsprechend der zu formenden Pits bilden, oder es werden flächige Bereiche beleuchtet und nach der Entwicklung das Relief aufgebracht. Im Falle der positiven Stamper wird die Information spiegelbildlich auf den Stamper aufgebracht. Die verbleibende Lackschicht wird vorteilhafterweise in einem Laugenbad mit einer anschließenden Wasserspülung entfernt.

Es ist besonders vorteilhaft, den Rohling als Scheibe aus gewalztem Metallblech zu fertigen, das lediglich in der gewünschten Form ausgestanzt oder geschnitten zu werden braucht. Durch Schleifen und Polieren kann die Qualität der Oberfläche des Metallrohlings noch weiter erhöht werden. Die nach dem erfindungsgemäßen Verfahren gefertigten Stamper sind besonders wiederstandsfähig und kostengünstig, wenn der Sockel aus kalt gewalztem Blech besteht, das auf dem Markt in hochreinem Zustand und mit spiegelnder Oberfläche erhältlich ist. Als Metall für den Rohling wird vorteilhafterweise Nickel einer Reinheit von etwa 99,5 % verwendet. Gewalztes Nickel-Blech ist wegen seiner verdichteten Kristallstruktur härter und damit widerstandsfähiger als durch Elektroforming abgeschiedenes Metall.

Vorteilhafterweise wird der fertige Stamper mit einer dünnen Schicht aus Platin bedeckt insbesondere bedampft. Dadurch wird seine Widerstandskraft erhöht und er läßt sich einfacher von der fertigen CD trennen. Zusätzlich wird ein gewisser Ausgleich der Rauhigkeiten auf dem Stamper erreicht, so daß sich der Kunststoff nicht in eventuellen Poren in den galvanisierten Spuren festsetzen kann. Die Herstellung der CD erfolgt vorteilhafterweise im Spritzguß- oder Heißprägevefahren.

Die Oberfläche des Rohlings wird vor der Beschichtung mit Resistlack vorteilhafterweise zunächst mit einem Haftgrund (Primer) versehen, der für einen guten Halt der nachfolgend auf zubringenden Lackschicht sorgt und der ein Einsickern von Säure unter den Lack im galvanischen Bad verhindert. Um eine homogene Verteilung der auf den Primer auf zubringenden Lackschicht zu erhalten, wird der Lack oder ein Harz, in einer Zentrifuge auf den Metallrohling aufgespritzt. Damit kann eine gleichbleibende Stärke des Lackes von wenigen Mikrometern erzeugt werden. Der Primer sollte so beschaffen sein, daß er entweder direkt durch den Entwicklungsprozeß oder durch ein nachfolgendes Bad angegriffen und entfernt wird.

In einer besonders vorteilhaften Ausführungsform ist die Deckschicht des Rohlings während der Belichtung im Verhältnis zum beleuchtenden Strahl um einen kleinen Winkel, insbesondere um einen Winkel von kleiner als 2°, aus der Senkrechten heraus geneigt. Dadurch wird verhindert, daß der einfallende Strahl und der reflektierte Strahl unterschiedliche Richtung haben und sich keine Interferenzen ausbilden können. Derartige Interferenzen würden die Intensität des Strahles beeinflußen.

Das erfindungsgemäße Verfahren wird anhand der Zeichnungen dargestellt und wird im folgenden näher beschrieben.

Es zeigen:
- **Figur 1**: einen Schnitt durch die Oberfläche eines Rohlings beim Schreiben,
- **Figur 2**: einen Schnitt durch die Oberfläche eines Rohlings beim Galvanisieren und
- **Figur 3**: die Oberfläche eines fertigen Stampers.

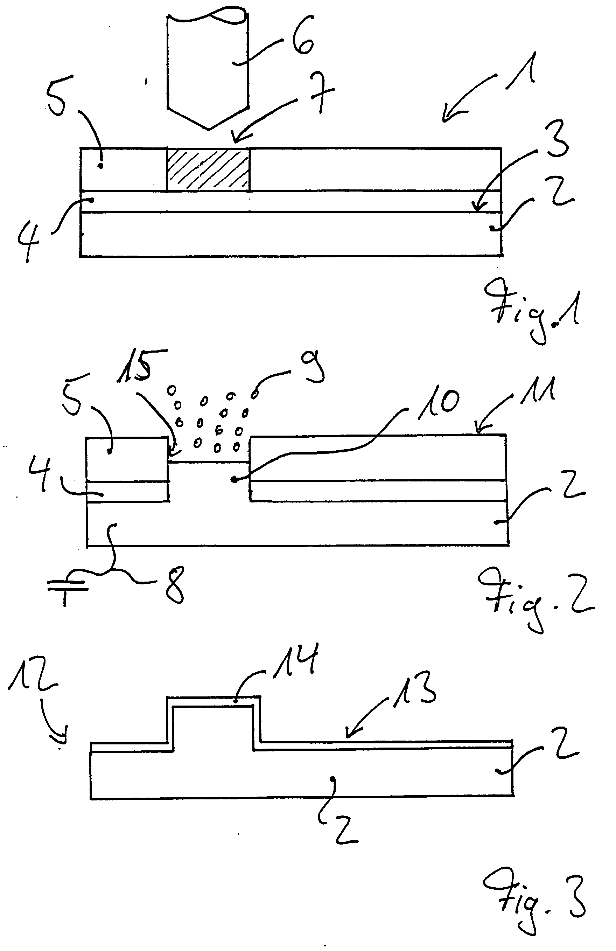

Figur 1 zeigt einen Rohling 1, der als Basis eine Scheibe 2 aus Metall insbesondere aus Nickel einer Reinheit von 99,5% aufweist. Die Scheibe 2 wurde in der entsprechenden Form aus Blech geschnitten oder gestanzt. Die Oberfläche 3 der Scheibe 2 ist geschliffen und hochglanzpoliert und mit einer Schicht Haftgrund 4 (Primer) überzogen. Der Primer 4 sorgt für die Versiegelung der Oberfläche 3 und bildet die Basis für eine Deckschicht aus photosensiblem Lack 5. Der Resistlack 5 weist eine besondere Sensibilität für Licht definierter Wellenlänge auf. Die Dicke der Schichten ist in den Figuren nicht maßstabsgetreu dargestellt. Während die Metallscheibe 2 eine Dicke von mehreren Millimetern aufweisen kann, ist der Primer 4 sehr dünn aufgetragen. Die Dicke der Deckschicht 5 beträgt einen bis einige Mikrometer.

Ein Laserstrahl 6 belichtet unter kontinuierlicher Drehung des Rohlings 1 einen Bereich 7 auf der Lackschicht 5. Die Wellenlänge des Laserstrahles 6 ist auf die Äbsorbtionseigenschaften des Lackes 5 abgestimmt. Die beleuchteten Bereiche bilden auf einer Spirale oder auf konzentrischen Kreisen liegende Lichtspuren 7 aus, welche die Information speichern. Dabei ist zu bemerken, daß die Drehung des Rohlings 1 beim Beleuchten entgegengesetzt der Laufrichtung der späteren Compakt Disk ist. Die Information wird somit spiegelbildlich auf den Rohling aufgebracht.

Der nachfolgende Entwicklungsvorgang wird nach einem herkömmlichen Verfahren vorgenommen. Dabei kann der Fortschritt des Vorganges mittels eines Lasers festgestellt werden, dessen Wellenlänge außerhalb der Sensibilität der Photorezeptoren liegt. Dieser Laser kann auch dazu benutzt werden, die Oberfläche 3 vom Primer 4 zu reinigen.

Nachdem der Belichtungsvorgang abgeschlossen ist, wird der belichtete Rohling in einem weiteren Verfahrensschritt einem Entwicklungsprozeß unterzogen, bei dem der Resistlack 5 innerhalb der Bereiche 7 abgetragen wird, so daß Ausmehmungen 15 (Figur 2) entstehen. Die Ausnehmungen 15 reichen bis auf die Oberfläche 3 des Rohlings 1, da der Haftgrund an dieser Stelle bei der Entwicklung ebenfalls abgetragen worden ist.

Der gereinigte Rohling 1 kommt in ein galvanisches Bad, wobei die Scheibe 2 über eine Leitung 8 auf ein entsprechendes Potential gelegt wird. Bei der Elektrolyse werden Metallionen 9 bewegt und setzen sich als Erhebung 10 auf der Oberfläche 3 ab. Die Zusammensetzung des elektrolytischen Bades ist so, daß sich Metall entsprechend der Metall der Scheibe 2 in diesem Falle also Nickel absetzt.

Bei der Elektrolyse werden somit die Vertiefungen 15 aufgefüllt. Die Stärke der Metallerhebung 10 wird über die Zeit, die die elektrische Spannung anliegt, eingestellt und beträgt etwa 30 Sekunden. Der elektrolytische Prozeß wird abgebrochen sobald die Vertiefungen 15 zu etwa 0.15 Mikrometern aufgefüllt sind.

Nach dem galvanischen Prozeß wird die verbleibende Deckschicht 5 und der Primer 4 in einem Laugebad entfernt. Nach einer letzten Reinigung liegt der fertige Stamper 12 mit den Metallerhebungen 10 gebrauchsfertig vor (Figur 3). Zur Veredelung des Stampers 12 wird die Druckfläche 13 mit einer Schicht Platin 14 bedampft.

Mittels des beschriebenen Verfahrens kann gleichfalls eine mit Information beschriebene Masterdisk aus Metall oder mit einer Metalloberfläche hergestellt werden, von der dann entsprechende Stamper abgeformt werden.

## Patentansprüche

1. Verfahren zur Herstellung einer Preßform (Stamper) für die Abformung eines informationstragenden optischen Speichermediums, wobei
- in einem Verfahrensschritt ein eine Deckschicht (3) aus Metall aufweisender Rohling (1) mit einer Schicht von strahlenempfindlichem Material (Resistlack) (5) überzogen wird,
- in einem weiteren Verfahrensschritt der Resistlack (5) mittels einer Strahlenquelle (6) entsprechend der zu speichernden Information beleuchtet wird,
- in einem weiteren Verfahrensschritt der Resistlack (5) einem Entwicklungsprozeß unterzogen wird, so daß die beleuchteten Bereiche (7) bis auf die Deckschicht (3) abgetragen werden,
- in einem weiteren Verfahrensschritt die Vertiefungen (15) bildenden abgetragenen Bereiche (7) in einem galvanischen Prozeß mit Metall (9) aufgefüllt werden und
- in einem weiteren Verfahrensschritt der verbleibende Resistlack (5) entfernt wird.

2. Verfahren nach Anspruch 1,
**dadurch gekennzeichnet,** daß die Strahlenquelle (6) eine Lichtquelle, insbesondere ein Laser, ist.

3. Verfahren nach Anspruch 1,
**dadurch gekennzeichnet,** daß die Strahlenquelle eine Ionenquelle, insbesondere eine Elektronenquelle, ist.

4. Verfahren nach einem der vorherigen Ansprüche,
**dadurch gekennzeichnet,** daß mittels der Strahlenquelle auf einer Spirale oder auf konzentrischen Kreisen liegende Spuren beleuchtet werden, die nach der Entwicklung entsprechende Vertiefungen (15) bilden.

5. Verfahren nach einem der vorherigen Ansprüche,
**dadurch gekennzeichnet,** daß mittels der Strahlenquelle flächige Bereiche beleuchtet werden, die nach der Entwicklung Vertiefungen bilden, wobei entlang einer Spirale oder entlang konzentrischer Kreise angeordnete Spuren unbeleuchtet bleiben.

6. Verfahren nach einem der vorherigen Ansprüche,
**dadurch gekennzeichnet,** daß der Rohling (1) eine Scheibe aus Metall ist.

7. Verfahren nach Anspruch 6,
**dadurch gekennzeichnet,** daß der Rohling (1) aus Blech geschnitten oder gestanzt wird.

8. Verfahren nach einem der vorherigen Ansprüche,
**dadurch gekennzeichnet,** daß eine Oberfläche (3) des Rohlings in einem Verfahrensschritt geschliffen und poliert wird und diese Oberfläche (3) die Deckschicht bildet.

9. Verfahren nach einem der vorherigen Ansprüche,
**dadurch gekennzeichnet,** daß der elektrolytischen Prozeß abgebrochen wird sobald die Spuren etwa 0.15 Mikrometer aufgefüllt sind.

10. Verfahren nach einem der vorherigen Ansprüche,
**dadurch gekennzeichnet,** daß das aufgalvanisierte Metall (9) dem Metall der Scheibe entspricht.

11. Verfahren nach einem der vorherigen Ansprüche,
**dadurch gekennzeichnet,** daß die verbleibende Lackschicht (5) in einem Laugenbad entfernt wird.

12. Verfahren nach den vorherigen Ansprüche,
**dadurch gekennzeichnet,** daß der Rohling (1) aus Nickel einer sehr hohen Reinheit von etwa 99% ist.

13. Verfahren nach den vorherigen Ansprüche,
**dadurch gekennzeichnet,** daß der fertige Stamper mit einer dünnen Schicht aus Platin (14) bedeckt wird.

14. Verfahren nach den vorherigen Ansprüche,
**dadurch gekennzeichnet,** daß die Information auf dem Stamper im Verhältnis zu der zu fertigenden Compakt Disk spiegelbildlich ist.

15. Verfahren nach den vorherigen Ansprüche,
**dadurch gekennzeichnet,** daß die Deckschicht des Rohlings (1) während des Beleuchtens im Verhältnis zum beleuchtenden Strahl um einen Winkel, insbesondere um einen Winkel von kleiner als 2°, aus der Senkrechten geneigt ist.

16. Mit Information beschriebene Masterdisk aus Metall oder mit einer Metalloberfläche hergestellt nach dem Verfahren nach den Ansprüchen 1-15 zur Herstellung eines Stampers.
